Europäisches Patentamt

(19) European Patent Office

Office européen des brevets

(11) Numéro de publication: **0 101 338 B1**

# (12) FASCICULE DE BREVET EUROPEEN

(45) Date de publication du fascicule du brevet:
07.01.87

(51) Int. Cl.⁴: **G 06 G 7/186, H 03 H 19/00**

(21) Numéro de dépôt: **83401334.4**

(22) Date de dépôt: **28.06.83**

(54) **Intégrateur différentiel bilinéaire à capacités commutées s'affranchissant des capacités parasites.**

(30) Priorité: **09.07.82 FR 8212105**

(43) Date de publication de la demande:
**22.02.84 Bulletin 84/8**

(45) Mention de la délivrance du brevet:
**07.01.87 Bulletin 87/2**

(84) Etats contractants désignés:
**DE FR GB IT NL**

(73) Titulaire: **SOCIETE POUR L'ETUDE ET LA FABRICATION DE CIRCUITS INTEGRES SPECIAUX - E.F.C.I.S., 17, avenue des Martyrs, F-38100 Grenoble (FR)**

(72) Inventeur: **Caillon, Christian, THOMSON-CSF SCPI 173, bld Haussmann, F-75379 Paris Cedex 08 (FR)**
Inventeur: **Tawfik, Mohamed, THOMSON-CSF SCPI 173, bld Haussmann, F-75379 Paris Cedex 08 (FR)**

(74) Mandataire: **Guérin, Michel et al, THOMSON-CSF SCPI 19, avenue de Messine, F-75008 Paris (FR)**

(56) Documents cités:
ELECTRONICS LETTERS, vol. 14, no. 12, juin 1978, pages 361-362, Hitchin Herts, G.B. G.C. TEMES: "The derivation of switched-capacitor filters from active-RC prototypes"
IEEE TRANSACTIONS ON CIRCUITS AND SYSTEMS, vol. CAS-28, no. 4, avril 1981, pages 265-270, New York, USA MAN SHEK LEE et al.: "Switched-capacitor filters using the LDI and bilinear transformations"
ELECTRONICS LETTERS, vol. 16, no. 5, février 1980, pages 173-174, Hitchin Herts, G.B. A. KNOB: "Novel strays-insensitive switched-capacitor integrator realising the bilinear Z-transform"
IEEE JOURNAL OF SOLID-STATE CIRCUITS, vol. SC-15, no. 3, juin 1980, pages 358-361, New York, USA G.C. TEMES: "Finite amplifier gain and bandwidth effects in switched-capacitor filters"

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

**Description**

La présente invention concerne les filtres à capacités commutées.

Ces filtres sont des filtres échantillonnés comportant un certain nombre de commutateurs travaillant à une fréquence d'échantillonnage plus élevée que la plus haute des fréquences de signal utile devant être transmise par le filtre. Cette fréquence est donnée par une horloge à deux ou plusieurs phases. Les filtres sont construits à partir d'amplificateurs opérationnels, de capacités non commutées et de capacités commutées, ces dernières ayant pour fonction de simuler le comportement de résistances de telle sorte que lorsqu'elles sont placées à l'entrée d'un amplificateur opérationnel bouclé par une capacité non commutée, elles permettent de réaliser un circuit ayant la fonction d'un intégrateur.

L'élément de base d'un filtre à capacités commutées est donc l'intégrateur, qui peut d'ailleurs facilement se transformer en additionneur-intégrateur ou soustracteur-intégrateur.

Or, par son principe même, l'intégrateur à capacités commutées ne peut réaliser une fonction d'intégration que de manière approchée puisqu'il fonctionne de manière discontinue par transferts de charge successifs au cours des phases successives de l'horloge de commande, l'intégration pure étant au contraire une fonction continue.

L'approximation peut être plus ou moins bonne selon le type d'intégrateur réalisé. Il n'y a pas, en effet, qu'une seule manière de commuter les capacités d'entrée pour réaliser une fonction de sommation des échantillons successifs d'une tension d'entrée.

Une intégration par la méthode dite «des rectangles avancés», consistant, pour obtenir le signal de sortie à un instant kT, à rajouter à la valeur du signal de sortie à l'instant (k-1)T la valeur du signal d'entrée à l'instant kT, ne donne pas le même résultat qu'une intégration par la méthode «des rectangles retardés» consistant à rajouter au signal de sortie à l'instant (k-1)T, le signal d'entrée à l'instant (k-1)T. T est la période d'échantillonnage, k un entier.

De même une intégration par la méthode «des trapèzes» consiste à rajouter la moyenne des signaux d'entrée aux instants kT et (k-1)T, et une intégration dite «LDI» (Lossless Discrete Integration) consiste à rajouter le signal d'entrée à l'instant (k-1/2)T, c'est-à-dire le signal d'entrée à une phase d'horloge intermédiaire entre deux instants d'échantillonnage successifs du signal de sortie. Ces divers types d'intégration conduisent à des intégrateurs dont les fonctions de transfert en z sont toutes différentes et correspondent respectivement à $-z/(z-1)$, $-1/(z-1)$, $-(z+1)/(z-1)$, $-z^{1/2}/(z-1)$.

Lorsqu'on étudie sur le plan du calcul ces divers modes d'intégration, on s'aperçoit qu'une erreur d'approximation par rapport à un intégrateur parfait existe aussi bien en ce qui concerne le module que la phase du signal de sortie, cette erreur étant fonction de la fréquence du signal transmis. L'intégrateur parfait est celui qui possède une fonction de transfert en 1/p, p étant la variable de Laplace; une méthode de conception de filtres à capacités commutées consiste à partir d'une fonction de transfert désirée, exprimée en fonction de la variable de Laplace p, à établir un schéma correspondant à partir d'intégrateurs de fonction 1/p et à remplacer ces intégrateurs par des intégrateurs à capacités commutées selon une transformation où la variable p est remplacée par l'une des fonctions en z définies ci-dessus. Les différentes transformations possibles conduisent à des approximations plus ou moins bonnes, en amplitude et en phase, du filtre classique par un filtre à capacités commutées.

Parmi ces transformations, la transformée bilinéaire où 1/p est remplacé par:

$$\frac{T}{2}\frac{z+1}{z-1}$$

c'est-à-dire celle qui correspond à une intégration par les trapèzes, ainsi que la transformée LDI où 1/p est remplacé par:

$$T\frac{z^{1/2}}{z-1}$$

présentent une erreur de phase nulle.

C'est pourquoi il est particulièrement intéressant de les utiliser.

Il y a d'ailleurs une autre bonne raison d'utiliser ces transformations: lorsqu'on part d'une fonction de transfert en p d'un filtre, on regarde toujours si cette fonction est stable (pôles à partie réelle négative); or, en introduisant la variable z par la transformée bilinéaire ou la transformée LDI, on aboutit à une fonction de transfert en z présentant des pôles et des zéros. La propriété très intéressante de ces deux transformations que si la fonction de transfert initiale en p était stable, la fonction de transfert en z sera également stable (tous les pôles en z auront un module inférieur à 1); partant d'un schéma de filtre classique stable on aboutira à un filtre à capacités commutées stable.

Toutes ces raisons font que les concepteurs de circuits ont cherché à imaginer des schémas d'intégrateurs à capacités commutées établissant réellement une fonction de transfert de type bilinéaire, c'est-à-dire en $(z+1)/(z-1)$.

Mais il n'est pas facile d'imaginer des schémas de circuits d'intégrateurs ayant à la fois la fonction de transfert théorique désirée et des qualités pratiques leur permettant d'avoir de bonnes performances.

En effet, l'intégrateur va en principe faire partie d'un circuit complexe intégré sur une pastille semiconductrice et il sera soumis aux inconvénients et limitations de la technologie employée. Par exemple, avec une technologie MOS (Metal – Oxyde – Semiconducteur) où les commutateurs sont des transistors à effet de champ à grille isolée, un problème crucial est celui des capacités parasites qui modifient les fonctions de transfert théoriquement attendues. Un autre problème est celui des amplificateurs opérationnels qui présentent des dérives dans le temps et d'autres inconvénients tels qu'une sensibilité aux variations de leur tension d'alimentation.

Un exemple d'intégrateur différentiel monté de manière symétrique est montré dans la revue Electronics Letters, vol. 14, no 12, du 8 juin 1978, article de G. TEMES, p. 361–362, «The derivation of Switched Capacitor Filters from Active RC Prototypes».

On pourra se référer utilement à l'article de MAN SHEK LEE et CHIEN CHANG dans la revue IEEE Transactions on circuits and systems, vol. CAS-28, no 4, avril 1981, pp. 265–270, où les auteurs expliquent l'intérêt de l'intégration bilinéaire et proposent un schéma simple d'intégrateur à capacités commutées et montrent qu'il peut être utile de prévoir un schéma plus complexe pour s'affranchir des capacités parasites.

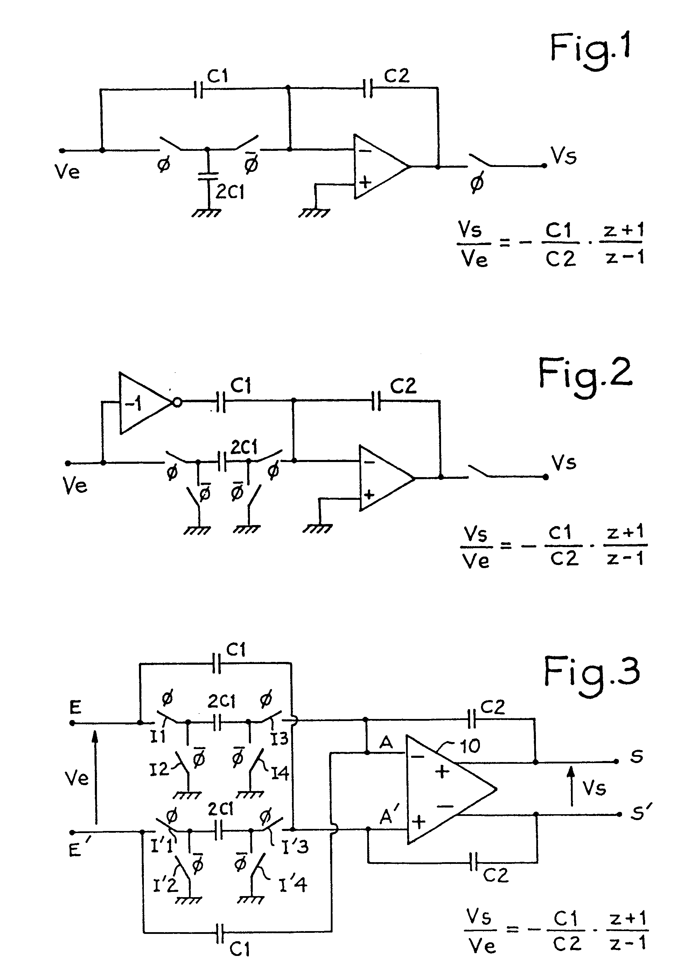

Le schéma simple est montré à la figure 1 ci-jointe, le schéma plus complexe à la figure 2; tous deux ont la même fonction de transfert en z qui est: $-(C1/C2)(z+1)/(z-1)$.

Mais le schéma de la figure 2 nécessite un amplificateur opérationnel supplémentaire servant d'inverseur; il occupe donc une surface de circuit plus grande et est sujet à des dérives et erreurs supplémentaires dues à cet amplificateur opérationnel.

Les tentatives faites jusqu'à maintenant pour réaliser des circuits intégrateurs de type bilinéaire ne sont donc pas suffisamment satisfaisantes.

La présente invention propose un nouveau circuit intégrateur à capacités commutées, ayant une fonction de transfert de type bilinéaire, et s'affranchissant des inconvénients des circuits proposés jusqu'à maintenant.

Ce circuit ne comporte qu'un amplificateur opérationnel et il est pourtant rendu insensible à la présence des capacités parasites qui se trouvent en parallèle sur les capacités commutées d'entrée de l'amplificateur. De plus, ce circuit est particulièrement insensible aux parasites d'horloge (qui, dans d'autres circuits tendent à passer à travers l'intégrateur), ainsi qu'aux variations de tension d'alimentation et aux dérives de l'amplificateur opérationnel.

Le circuit selon l'invention comprend un amplificateur différentiel monté de manière symétrique avec une entrée inverseuse, une entrée non-inverseuse, deux sorties, une capacité non-commutée de contre-réaction entre une sortie et l'entrée inverseuse et une autre capacité non-commutée identique entre l'autre sortie et l'entrée non-inverseuse, une capacité de liaison directe entre une première entrée du circuit et l'entrée non-inverseuse de l'amplificateur différentiel, une autre capacité de liaison directe identique entre une deuxième entrée du circuit et l'entrée inverseuse, une capacité commutée entre la première entrée du circuit et l'entrée inverseuse et une capacité commutée identique entre la deuxième entrée du circuit et l'entrée non-inverseuse, la valeur des capacités commutées étant double de la valeur des capacités de liaison directe. Une horloge établit la commutation des capacités commutées de telle sorte que dans une première phase de chaque période d'horloge les capacités commutées soient en série une entrée du circuit et une entrée de l'amplificateur, tandis que dans une deuxième phase ces capacités aient leurs deux armatures reliées à une masse du circuit. Cette masse est en principe reliée au substrat du circuit intégré comportant l'intégrateur selon l'invention.

Brève description des dessins
   – les figures 1 et 2 représentent deux intégrateurs bilinéaires de l'art antérieur,
   – la fig. 3 représente l'intégrateur selon l'invention,
   – la fig. 4 représente un intégrateur-additionneur,
   – la fig. 5 représente un filtre passe bas du deuxième ordre qui est l'équivalent d'un circuit RLC série;

Description détaillée de l'invention
   Sur la figure 3, l'amplificateur est désigné par la référence 10, ses entrées inverseuse et non-inverseuse par A et A' respectivement, ses sorties positive et négative par S et S' respectivement; les capacités de bouclage ont une valeur C2, l'une étant connectée entre A et S, l'autre entre A' et S'; les capacités de liaison directe ont une valeur C1, l'une étant connectée entre une première entrée E du circuit intégrateur et l'entrée A', l'autre entre une deuxième entrée E' du circuit intégrateur et l'entrée A.

Les capacités commutées ont pour valeur 2C1 (donc le double des capacités de liaison directe), l'une ayant une armature reliée par un commutateur I1 et par un commutateur I2 respectivement à l'entrée E et à une masse électrique, et l'autre armature reliée par un commutateur I3 à l'entrée A et par un commutateur I4 à la masse. L'autre capacité commutée a une armature reliée par un commutateur I'1 à l'entrée E' par un commutateur I'2 à la masse, et l'autre armature reliée par un commutateur I'3 à l'entrée A' et par un commutateur I'4 à la masse. I1, I3, I'1, I'3 sont fermés pendant une première phase de chaque période d'horloge, I2, I4, I'2, I'4 pendant une deuxième phase disjointe de la première phase.

Les commutateurs sont de préférence des transistors à effet de champ à grille isolée dont le substrat est à la masse.

Le signal d'entrée est appliqué au circuit sous forme d'une tension différentielle Ve entre E et E'. La sortie est une tension différentielle Vs apparaissant entre S et S'; et on a bien $Vs/Ve = -(C1/C2)(z+1)/(z-1)$ soit une intégration de type bilinéaire.

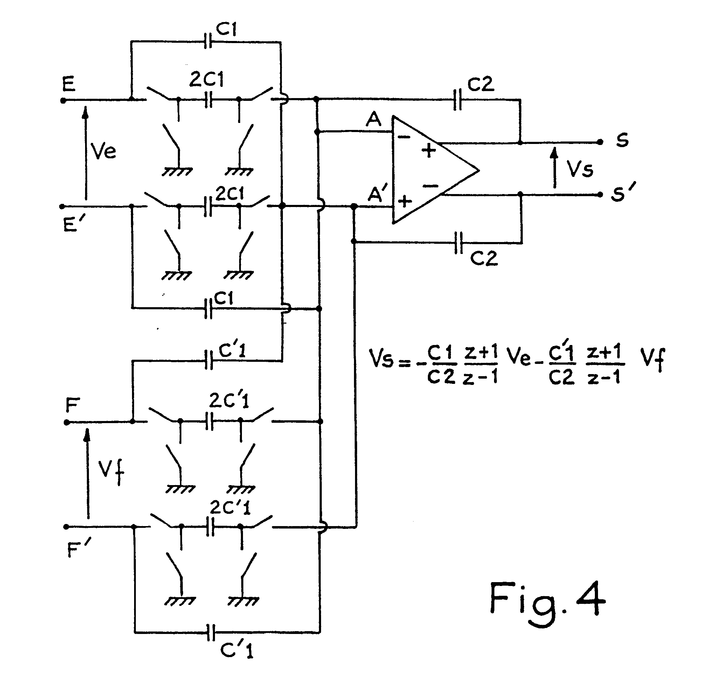

La figure 4 montre comment on peut avec le même circuit de base effectuer une addition de l'intégrale de deux tensions d'entrée Ve et Vf pour obtenir une tension de sortie Vs qui serait:

$$Vs = -\frac{C1}{C2}\frac{z+1}{z-1}Ve - \frac{C'1}{C2}\frac{z+1}{z-1}Vf$$

Pour cela, on connecte simplement à chacune des entrées A et A′ de l'amplificateur opérationnel 10 une capacité de liaison directe de valeur C1 venant respectivement de deux autres entrées de circuit F′ et F, Vf étant la tension différentielle entre F et F′, et une capacité commutée de valeur 2C′1 connectée entre A et F pour l'une entre A′ et F′ pour l'autre de la même manière que les capacités commutées 2C1 entre A et E et entre A′ et E′.

On peut ainsi multiplier les couples d'entrée du circuit intégrateur, et notamment prévoir que l'un de ces couples d'entrées provient directement des sorties S et S′ de l'amplificateur opérationnel lui-même.

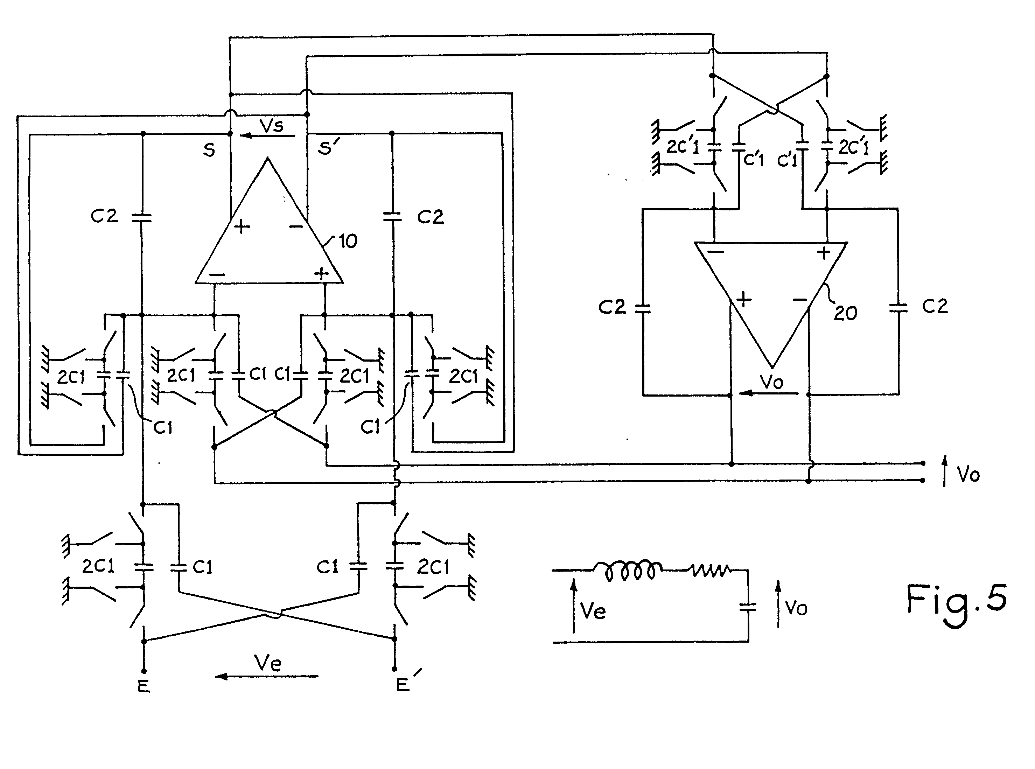

Le schéma de la figure 5 est un exemple d'application pour un filtre passe bas du deuxième ordre réalisant l'équivalent d'un circuit RLC série avec entrée sur le circuit série et sortie sur la capacité.

Le filtre à capacités commutées comprend deux intégrateurs conformes à celui des figures 3 et 4. Le premier comprend un amplificateur différentiel 10 et il reçoit et additionne en les intégrant trois couples de signaux d'entrée: la tension d'entrée proprement dite du filtre Ve, la tension de sortie Vs de l'amplificateur 10, et l'inverse de la tension de sortie (Vo) du deuxième circuit intégrateur. Chacun de ces couples est appliqué à travers deux capacités de liaison directe de valeur C1 et deux capacités commutées de valeur 2C1. Le deuxième circuit intégrateur, dont la tension de sortie Vo constitue la tension de sortie du filtre, reçoit la tension de sortie Vs du premier circuit intégrateur à travers des capacités C′1 non commutées et des capacités 2C′1 commutées.

Sur les différentes figures, la commande des commutateurs n'est pas représentée.

## Revendications

1. Circuit intégrateur à capacités commutées, comprenant un amplificateur différentiel (10) monté de manière symétrique, ayant une entrée inverseuse (A), une entrée non-inverseuse (A′), deux sorties (S et S′), une capacité non commutée (C2) de contre-réaction entre une sortie (S) et l'entrée inverseuse, une autre capacité de contre-réaction identique entre l'autre sortie (S′) et l'entrée non-inverseuse (A′), caractérisé en ce qu'il comprend une capacité de liaison directe (C1) entre une première entrée (E) du circuit et l'entrée non-inverseuse (A′), une autre capacité de liaison directe identique (C1) entre une deuxième entrée du circuit (E′) et l'entrée inverseuse (A), une capacité commutée (2C1) entre la première entrée (E) du circuit et l'entrée inverseuse (A), et une capacité commutée identique entre la deuxième entrée (E′) du circuit et l'entrée non-inverseuse (A′), que la valeur de chaque capacité commutée est double de la valeur de chaque capacité de liaison directe, que les capacités son commutées périodiquement selon deux phases d'horloge, de telle sorte que dans une phase les capacités commutées soient en série entre une entrée du circuit et une entrée de l'amplificateur, et que dans une autre phase les capacités aient leurs armatures reliées à une masse du circuit.

2. Circuit intégrateur selon la revendication 1, caractérisé par le fait que l'amplificateur comprend d'autres couples d'entrée (F, F′) ces couples d'entrée étant reliés aux entrées de l'amplificateur par un agencement de capacités de liaison directe et de capacités commutées du même type que celui du premier couple d'entrée (E, E′).

3. Filtre à capacités commutées, caractérisé par le fait qu'il comprend au moins un intégrateur selon l'une quelconque des revendications 1 et 2.

## Patentansprüche

1. Integratorkreis mit geschalteten Kondensatoren und einem Differentialverstärker (10) in symmetrischer Anordnung, der einen invertierenden Eingang (A), einen nicht-invertierenden Eingang (A′), zwei Ausgänge (S und S′), einen nicht-geschalteten Rückkopplungskondensator (C2) zwischen einem Ausgang (S) und dem invertierenden Eingang und einen gleichgrossen weiteren Rükkopplungskondensator zwischen dem anderen Ausgang (S′) und dem nicht-invertierenden Eingang (A′) aufweist, dadurch gekennzeichnet, dass der Integratorkreis einen direkten Verbindungskondensator (C1) zwischen einem ersten Eingang (E) des Kreises und dem nicht-invertierenden Eingang (A′), einen gleichgrossen weiteren direkten Verbindungskondensator (C1) zwischen einem zweiten Eingang des Kreises (E′) und dem invertierenden Eingang (A), einen geschalteten Kondensator (2C1) zwischen dem ersten Eingang (E) des Kreises und dem invertierenden Eingang (A) und einen gleichgrossen geschalteten Kondensator zwischen dem zweiten Eingang (E′) des Kreises und dem nicht-invertierenden Eingang (A′) aufweist, dass der Wert jedes geschalteten Kondensators doppelt so gross wie der Wert jedes der direkten Verbindungskondensatoren ist und dass die Kondensatoren periodisch gemäss zwei Taktphasen geschaltet werden, derart, dass in einer Phase die geschalteten Kondensatoren in Reihe zwischen einem Eingang des Kreises und einem Eingang des Verstärkers liegen und dass in einer zweiten Phase die Kondensatoren mit ihren Belägen an eine Masse des Kreises angeschlossen sind.

2. Integratorkreis nach Anspruch 1, dadurch gekennzeichnet, dass der Verstärker weitere Paare von Eingängen (F, F′) aufweist, die über eine Anordnung von direkten Verbindungskondensatoren und geschalteten Kondensatoren von derselben Art an die Eingänge des Verstärkers angeschlossen sind wie das erste Paar von Eingängen (E, E′).

3. Filter mit geschalteten Kondensatoren, dadurch gekennzeichnet, dass es mindestens einen Integrator nach einem beliebigen der Ansprüche 1 und 2 enthält.

## Claims

1. An integrator circuit comprising switched capacitors and a symmetrically mounted differential amplifier (10) having an inverting input (A), a non-inverting input (A′), two outputs (S and S′), a feedback capacitor (C2), which is not switched and which is connected between one output (S) and the inverting input, an identical further feedback capacitor connected between the other output (S′) and the non-inverting input (A′), characterized in that the circuit comprises a direct connection capacitor (C1) between a first circuit input (E) and the non-inverting input (A′), an identical further direct connection capacitor (C1) between a second circuit input (E′) and the inverting input (A), a switched capacitor (2C1) connected between the first circuit input (E) and the inverting input (A) and an identical switched capacitor between the second circuit input (E′) and the non-inverting input (A′), that the capacitance of each of the switched capacitors is twice the capacitance of each direct connection capacitor, that the capacitors are switched periodically according to two clock phases in such a way that during a first phase, the switched capacitors are connected in series between one circuit input and an amplifier input and that during the second phase, the capacitor plates are connected to an earth terminal of the circuit.

2. An integrator circuit according to claim 1, characterized in that the amplifier comprises additional pairs of inputs (F, F′), these pairs of inputs being connected to the amplifier inputs via an arrangement of direct connection capacitors and switched capacitors of the same type as that of the first pair of inputs (E, E′).

3. A filter having switched capacitors, characterized in that it comprises at least an integrator according to any one of claims 1 and 2.

# Fig.1

$$\frac{Vs}{Ve} = -\frac{C1}{C2} \cdot \frac{z+1}{z-1}$$

# Fig.2

$$\frac{Vs}{Ve} = -\frac{C1}{C2} \cdot \frac{z+1}{z-1}$$

# Fig.3

$$\frac{Vs}{Ve} = -\frac{C1}{C2} \cdot \frac{z+1}{z-1}$$

$$Vs = -\frac{C1}{C2}\frac{z+1}{z-1}Ve - \frac{C'1}{C2}\frac{z+1}{z-1}Vf$$

Fig.4

Fig.5